(19) Europäisches Patentamt / European Patent Office / Office européen des brevets

(11) **EP 4 350 925 B1**

(12) **FASCICULE DE BREVET EUROPEEN**

(45) Date de publication et mention
de la délivrance du brevet:
**21.01.2026 Bulletin 2026/04**

(21) Numéro de dépôt: **23196017.0**

(22) Date de dépôt: **07.09.2023**

(51) Classification Internationale des Brevets (IPC):
***H02J 3/14*** *(2026.01)*

(52) Classification Coopérative des Brevets (CPC):
**H02J 3/14**

(54) **SURVEILLANCE ET OPTIMISATION DE LA CONSOMMATION ELECTRIQUE**

ÜBERWACHUNG UND OPTIMIERUNG DES STROMVERBRAUCHS

POWER CONSUMPTION MONITORING AND OPTIMIZATION

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **29.09.2022 FR 2209908**

(43) Date de publication de la demande:
**10.04.2024 Bulletin 2024/15**

(73) Titulaire: **Sagemcom Energy & Telecom SAS 92270 Bois-Colombes (FR)**

(72) Inventeurs:
• **TEBOULLE, Henri**
  **92270 BOIS-COLOMBES (FR)**
• **GRINCOURT, Christophe**
  **92270 BOIS-COLOMBES (FR)**

(74) Mandataire: **Cabinet Boettcher et al 5, rue de Vienne 75008 Paris (FR)**

(56) Documents cités:
WO-A1-2011/101476     WO-A1-2014/147959
JP-A- 2009 011 100     US-A- 5 666 254
US-A1- 2009 001 948

## Description

L'invention concerne le domaine des compteurs électriques dits « intelligents ».

### ARRIERE PLAN DE L'INVENTION

On recherche actuellement des solutions innovantes et efficaces permettant de limiter la consommation électrique des utilisateurs finaux (abonnés) raccordés au réseau électrique. Il est bien évident que la limitation de la consommation électrique de chacun présente non seulement un intérêt indéniable en matière d'écologie, mais est aussi très avantageuse pour le pouvoir d'achat des utilisateurs.

On connaît une solution pour réduire la consommation électrique, qui utilise des délesteurs électriques.

Un délesteur électrique est un équipement qui est installé chez l'utilisateur, à proximité du compteur. Le délesteur électrique coupe l'alimentation de certains appareils non prioritaires au moment de l'appel de courant, lorsque la consommation dépasse un certain seuil. Les appareils non prioritaires concernés, ainsi que les séquences de délestage, peuvent être définis par l'utilisateur. Les appareils non prioritaires comprennent typiquement les radiateurs électriques et le ballon d'eau chaude.

Cette solution est efficace et permet non seulement de réaliser des économies d'énergie importantes, mais aussi d'éviter de faire disjoncter l'installation lorsque la puissance sollicitée est trop élevée. Une solution similaire est divulguée dans la demande de brevet WO2014/147959.

Cependant, cette solution nécessite une installation spécifique et personnalisée chez l'utilisateur, et est donc relativement coûteuse et complexe à mettre en œuvre.

### OBJET DE L'INVENTION

L'invention a pour objet de contrôler et d'optimiser la consommation électrique d'un utilisateur, de manière simple et peu coûteuse à mettre en œuvre.

### RESUME DE L'INVENTION

En vue de la réalisation de ce but, on propose un procédé de surveillance, utilisant un compteur électrique agencé pour mesurer une consommation électrique d'une installation et comprenant un limiteur de courant agencé pour limiter sélectivement un courant fourni à l'installation, le procédé de surveillance comprenant les étapes, répétées chaque jour courant, pour chaque période courante d'un ensemble prédéterminé d'au moins une période successive définie dans le jour courant, de :

- vérifier une première condition prédéterminée associée à ladite période courante ;

- si la première condition prédéterminée est vérifiée, activer le limiteur de courant pour limiter le courant fourni à l'installation jusqu'à la fin de ladite période courante.

Le procédé de surveillance, qui peut être mis en œuvre par le compteur lui-même ou bien à distance, permet donc, chaque jour courant, de limiter la consommation électrique de l'installation sur la base de conditions prédéterminées associées à des périodes du jour courant. Le ou les composants formant le limiteur de courant sont directement intégrés dans le compteur et sont les mêmes pour tous les compteurs, de sorte que la mise en œuvre du procédé de surveillance ne nécessite ni intervention particulière ni installation spécifique et personnalisée chez l'utilisateur.

On propose de plus un procédé de surveillance tel que précédemment décrit, le compteur électrique comprenant de plus un organe de coupure agencé pour couper sélectivement le courant fourni à l'installation, le procédé de surveillance comprenant en outre les étapes, pour chaque période courante, de :

- vérifier une deuxième condition prédéterminée associée à ladite période courante ;
- si la deuxième condition prédéterminée est vérifiée, piloter l'organe de coupure de manière à couper le courant fourni à l'installation jusqu'à la fin de ladite période courante.

On propose de plus un procédé de surveillance tel que précédemment décrit, dans lequel la première condition prédéterminée est qu'une consommation électrique cumulée de l'installation sur ladite période courante est supérieure à un premier seuil prédéterminé.

On propose de plus un procédé de surveillance tel que précédemment décrit, dans lequel la deuxième condition prédéterminée est qu'une consommation électrique cumulée de l'installation sur ladite période courante est supérieure à un deuxième seuil prédéterminé lui-même supérieur au premier seuil prédéterminé.

On propose de plus un procédé de surveillance tel que précédemment décrit, dans lequel le premier seuil prédéterminé et/ou le deuxième seuil prédéterminé dépendent de ladite période courante et/ou dudit jour courant et/ou d'une période de l'année à laquelle appartient ledit jour courant.

On propose de plus un procédé de surveillance tel que précédemment décrit, dans lequel la vérification de la première condition prédéterminée consiste à vérifier, dans une table prédéfinie, que ladite période courante est associée à une première information selon laquelle le courant fourni à l'installation doit être limité pendant toute ladite période courante.

On propose de plus un procédé de surveillance tel que précédemment décrit, dans lequel la vérification de la deuxième condition prédéterminée consiste à vérifier, dans la table prédéfinie, que ladite période courante est associée à une deuxième information selon laquelle le courant fourni à l'installation doit être coupé pendant toute ladite période courante.

On propose de plus un procédé de surveillance tel que précédemment décrit, le compteur comprenant de plus un organe de coupure agencé pour couper sélectivement le courant fourni à l'installation, l'organe de coupure comprenant un interrupteur pour chaque phase d'un réseau de distribution auquel est reliée l'installation, le limiteur de courant comprenant, pour chaque interrupteur de l'organe de coupure, un relais et un composant résistif montés en parallèle de l'interrupteur, l'activation du limiteur de courant pour limiter le courant fourni à l'installation comprenant les étapes de fermer le ou les relais simultanément puis, ensuite, d'ouvrir le ou les interrupteurs simultanément.

On propose de plus un compteur électrique agencé pour mesurer une consommation électrique d'une installation, le compteur électrique comprenant un limiteur de courant agencé pour limiter sélectivement un courant fourni à l'installation, le compteur électrique comprenant en outre une unité de traitement agencée pour mettre en œuvre le procédé de surveillance tel que précédemment décrit.

On propose de plus un compteur électrique tel que précédemment décrit, le compteur électrique comprenant de plus un organe de coupure agencé pour couper sélectivement le courant fourni à l'installation, l'organe de coupure comprenant un interrupteur pour chaque phase d'un réseau de distribution auquel est reliée l'installation, le limiteur de courant comprenant, pour chaque interrupteur de l'organe de coupure, un relais et un composant résistif montés en parallèle de l'interrupteur, l'unité de traitement étant agencée, pour activer le limiteur de courant, pour fermer le ou les relais simultanément puis, ensuite, pour ouvrir le ou les interrupteurs simultanément.

On propose de plus un programme d'ordinateur comprenant des instructions qui conduisent l'unité de traitement du compteur électrique tel que précédemment décrit à exécuter les étapes du procédé de surveillance tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en œuvre particuliers non limitatifs de l'invention.

BREVE DESCRIPTION DES DESSINS

Il sera fait référence aux dessins annexés parmi lesquels :

[Fig. 1] la figure 1 représente un compteur électrique monophasé ;
[Fig. 2] la figure 2 représente des étapes d'un procédé de surveillance ;

[Fig. 3] la figure 3 représente un compteur électrique triphasé.

DESCRIPTION DETAILLEE DE L'INVENTION

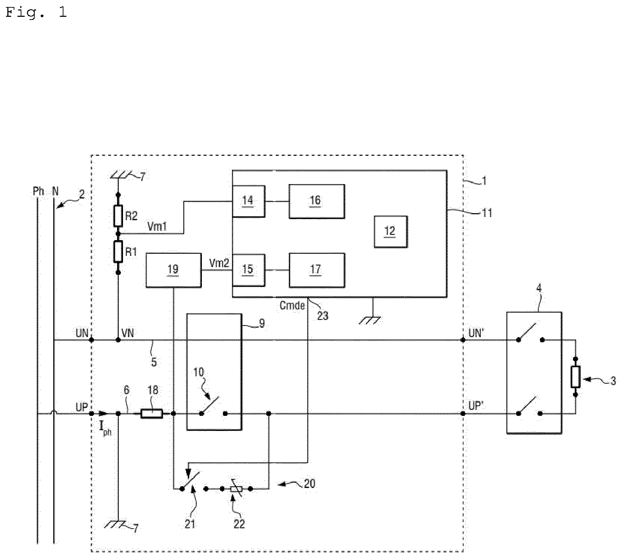

En référence à la figure 1, l'invention est tout d'abord mise en œuvre dans un compteur électrique monophasé 1.

Le compteur 1 est destiné à mesurer une énergie électrique fournie par une source, en l'occurrence par un réseau de distribution 2, à l'installation électrique 3 d'un utilisateur (abonné).

Le réseau de distribution 2 est un réseau monophasé et comporte une phase Ph et un neutre N. Le compteur 1 récupère la phase et le neutre du réseau 2 pour réaliser les mesures métrologiques.

Un disjoncteur 4 est positionné à la frontière entre le réseau de distribution 2 et l'installation 3. Le disjoncteur 4, qui peut être actionné par l'utilisateur, a notamment pour rôle de protéger l'installation 3 en s'ouvrant lorsqu'un sur-courant, résultant par exemple d'un court-circuit en aval du disjoncteur 4, survient sur le réseau de distribution 2. Ici, par « en aval », on entend du côté de l'installation 3 et par « en amont », on entend du côté du réseau de distribution 2.

Le compteur 1 comprend une borne d'entrée UP reliée à la phase Ph du réseau 2 et une borne d'entrée UN reliée au neutre N. Le compteur 1 comprend de plus deux bornes de sortie UP' et UN' reliées au disjoncteur 4, qui est lui-même relié à l'installation 3.

Le compteur 1 comporte un conducteur de neutre 5 relié à la borne d'entrée UN.

Le compteur 1 comporte de plus un conducteur de phase 6 relié à la borne d'entrée UP. Le conducteur de phase 6 est relié à une masse électrique 7 du compteur 1.

Le compteur 1 comprend de plus un organe de coupure 9 qui comprend un interrupteur 10 monté sur le conducteur de phase 6. L'organe de coupure 9 est notamment utilisé pour couper ou rétablir à distance l'alimentation de l'installation 3 (symbolisée ici par une charge) en cas, par exemple, de résiliation de l'abonnement ou de non-respect du contrat d'abonnement.

Le compteur 1 comporte de plus une partie applicative et une partie métrologie.

La partie applicative (non représentée) comprend un microcontrôleur application.

La partie métrologie comprend un microcontrôleur de métrologie 11, dont la fonction primaire est de produire des mesures d'un certain nombre de paramètres permettant d'évaluer la consommation électrique de l'installation 3.

La partie métrologie comprend aussi une ou des mémoires 12 reliées à ou intégrées dans le microcontrôleur 11. Au moins l'une de ces mémoires forme un support d'enregistrement lisible par ordinateur, sur lequel est enregistré au moins un programme d'ordinateur comprenant des instructions qui conduisent le microcontrôleur 11 exécuter au moins certaines des étapes du procédé de surveillance qui sera décrit plus bas.

Le microcontrôleur 11 intègre un premier convertisseur analogique numérique (CAN) 14, un deuxième CAN 15, un module de mesure de tension 16 et un module de mesure de courant 17.

La partie métrologie comprend aussi un capteur de tension agencé pour produire des mesures de tension pour évaluer une tension de neutre VN présente sur le neutre N.

Le capteur de tension comprend ici un pont diviseur de tension comprenant une première résistance de mesure R1 et une deuxième résistance de mesure R2. La première résistance de mesure R1 a une première borne reliée au conducteur de neutre 5 à proximité (et en aval) de la borne d'entrée UN. La deuxième résistance de mesure R2 a une première borne reliée à la masse électrique 7. La deuxième borne de la première résistance de mesure R1 et la deuxième borne de la deuxième résistance de mesure R2 sont reliées entre elles et à une entrée du microcontrôleur 11 à laquelle est reliée une entrée du premier CAN 14.

Le niveau de la tension mesurée Vm1 est adapté (grâce au pont diviseur R1, R2) afin d'éviter des saturations au niveau du premier CAN 14, et de manière à appliquer en entrée du premier CAN 14 des signaux ayant des niveaux significatifs (et correspondant à la plage d'entrée du premier CAN 14).

Le premier CAN 14 numérise donc la tension Vm1. Le module de mesure de tension 16 produit, à partir des échantillons produits par le premier CAN 14, des mesures de tension (efficace) permettant d'évaluer la tension de neutre VN.

La partie métrologie comprend aussi un capteur de courant agencé pour produire des mesures de courant représentatives d'un courant de phase Iph circulant sur le conducteur de phase 6.

Le capteur de courant comprend un *shunt* 18 monté sur le conducteur de phase 6 et positionné entre la borne d'entrée UP et l'interrupteur 10 de l'organe de coupure 9.

La partie métrologie comprend aussi une chaîne de mesure de courant 19 présentant un gain connu. La chaîne de mesure de courant 19 est reliée à la borne du *shunt* 18 qui est reliée à l'interrupteur 10 de l'organe de coupure 9, l'autre borne du *shunt* 18 étant reliée à la masse 7 et à la borne d'entrée UP.

La sortie de la chaîne de mesure de courant 19 est reliée à une entrée du microcontrôleur 11 à laquelle est reliée une entrée du deuxième CAN 15.

La tension Vm2 en sortie de la chaîne de mesure de courant 19 est une tension image du courant de phase Iph.

Le niveau de la tension Vm2 est adapté (grâce au gain de la chaîne de mesure de courant 19) afin d'éviter des saturations au niveau du deuxième CAN 15, et de manière à appliquer en entrée du deuxième CAN 15 des signaux ayant des niveaux significatifs (et correspondant à la plage d'entrée du deuxième CAN 15).

Le deuxième CAN 15 numérise la tension Vm2. Le module de mesure de courant 17 produit, à partir des échantillons produits par le deuxième CAN 15, des mesures de courant permettant d'évaluer le courant de phase Iph.

Le compteur 1 comporte de plus un limiteur de courant 20 agencé pour limiter sélectivement le courant fourni à l'installation 3 (courant de phase Iph).

Le limiteur de courant 20 comprend ici un relais d'activation 21 de la limitation de courant (30A typiquement), et un composant résistif 22 relié en série avec le relais 21. Le relais 21 et le composant résistif 22 sont montés en parallèle de l'interrupteur 10 de l'organe de coupure 9.

Plus précisément, le relais 21 comprend une première borne reliée à la borne de l'interrupteur 10 qui est reliée au *shunt* 18, et une deuxième borne qui est reliée à une première borne du composant résistif 22. La deuxième borne du composant résistif 22 est reliée à la borne de l'interrupteur 10 qui est reliée à la borne de sortie UP' du compteur 1.

Le composant résistif est ici une thermistance CTP (thermistance à Coefficient de Température Positif).

On fournit ici deux exemples de composant pouvant être utilisés :

- CTP Vishay 305C9 : ce composant supporte un courant pic de 36A et agit en limiteur de courant lorsque le courant atteint quelques ampères avec une énergie consommée maximale par la CTP de l'ordre du Watt ;
- CTP TDK EPCOS PTC C840 : ce composant correspond à un courant pic de 4.1A et agit en limiteur de courant lorsque le courant atteint quelques ampères avec une énergie consommée maximale par la CTP de l'ordre du Watt.

Le microcontrôleur 11 comprend une sortie 23 reliée au relais 21, par laquelle le microcontrôleur 11 transmet au relais 21 un signal de commande Cmde pour le piloter.

L'activation du limiteur de courant 20 pour limiter le courant fourni à l'installation consiste tout d'abord à fermer le relais 21, puis ensuite à ouvrir l'interrupteur 10 de l'organe de coupure 9.

On décrit maintenant le procédé de surveillance, qui est ici mis en œuvre par le microcontrôleur 11.

Le procédé de surveillance a pour but de limiter ou de de couper l'électricité pour éviter que la consommation de l'installation 3 ne soit trop importante.

Chaque jour courant est divisé en un ensemble prédéterminé d'au moins une période successive Pk, k variant de 1 à N.

Chaque période Pk a pour durée Hk et on a donc, pour chaque jour courant :

$$\sum_{k=1}^{N} Hk = 24\ heures$$

Les durées Hk de ces périodes Pk ne sont pas toutes nécessairement identiques.

La limitation et le contrôle de la consommation sont réalisés période par période (et non pas quotidiennement, sauf si le jour courant comporte une seule période).

Ces périodes sont préprogrammées dans une table prédéfinie qui est stockée dans l'une des mémoires 12 de la partie métrologie.

Chaque jour courant, pour chaque période courante, le microcontrôleur 11 :

- vérifie une première condition prédéterminée associée à ladite période courante ;
- si la première condition prédéterminée est vérifiée, le microcontrôleur 11 active le limiteur de courant 20 pour limiter le courant fourni à l'installation 3 jusqu'à la fin de ladite période courante.

De plus, pour chaque période courante, le microcontrôleur 11 :

- vérifie une deuxième condition prédéterminée associée à ladite période courante ;
- si la deuxième condition prédéterminée est vérifiée, le microcontrôleur 11 pilote l'organe de coupure 9 de manière à couper le courant fourni à l'installation 3 jusqu'à la fin de ladite période courante.

Ici, la première condition prédéterminée est qu'une consommation électrique cumulée de l'installation 3 sur ladite période courante est supérieure à un premier seuil prédéterminé, et la deuxième condition prédéterminée est qu'une consommation électrique cumulée de l'installation 3 sur ladite période courante est supérieure à un deuxième seuil prédéterminé lui-même supérieur au premier seuil prédéterminé.

Par « consommation », on entend ici toute grandeur représentative de l'énergie électrique distribuée à l'installation : courant, énergie, puissance, etc.

Le premier seuil prédéterminé et/ou le deuxième seuil prédéterminé peuvent dépendre de ladite période courante et/ou dudit jour courant et/ou d'une période de l'année à laquelle appartient ledit jour courant.

Il peut en effet être pertinent, par exemple, d'autoriser une consommation plus importante le matin (avant de partir au travail ou à l'école) et le soir (au retour).

Il peut aussi être pertinent, par exemple, d'autoriser une consommation plus importante le week-end ou lors d'un jour férié.

Il peut en outre être pertinent, par exemple, d'autoriser une consommation plus importante l'hiver que l'été.

Les premiers seuils prédéterminés et les deuxièmes seuils prédéterminés sont donc des seuils préprogrammés qui sont associés dans la table prédéfinie de la mémoire 12 aux périodes de l'ensemble prédéterminé de périodes successives.

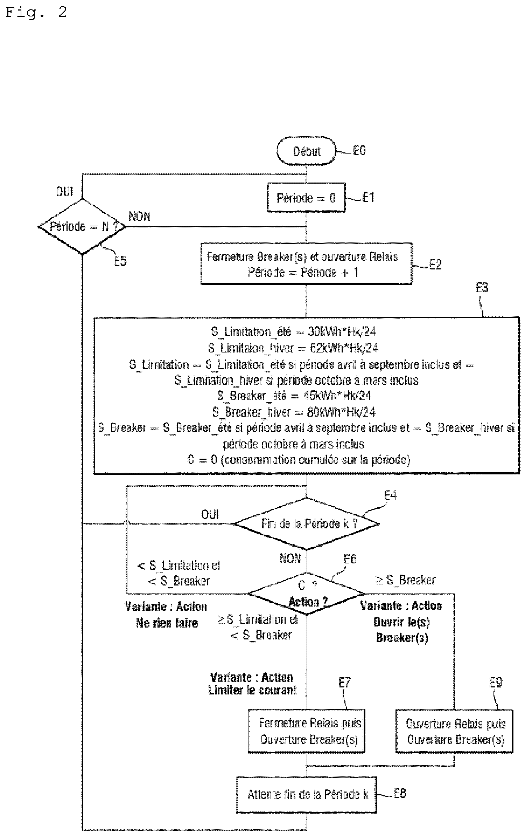

On décrit, en référence à la figure 2, un mode de réalisation particulier du procédé de surveillance.

Le procédé débute à l'étape E0.

La variable « Période » est initialisée à 0 (étape E1).

Le microcontrôleur 11 ferme l'organe de coupure 9 et ouvre le relais 21. Le microcontrôleur 11 incrémente la variable Période :

Période = Période + 1 (étape E2).

Les variables suivantes sont initialisées par le microcontrôleur 11 (étape E3) :

- S_Limitation_été = 30kWh*Hk/24 ;
- S_Limitation_hiver = 62kWh*Hk/24 ;
- S_Limitation = S_Limitation_été si le jour courant appartient à une période allant d'avril à septembre inclus, et = S_Limitation_hiver si le jour courant appartient à une période allant d'octobre à mars inclus ;
- S_Breaker_été = 45kWh*Hk/24 ;
- S_Breaker_hiver = 80kWh*Hk/24 ;
- S_Breaker = S_Breaker_été si le jour courant appartient à une période allant d'avril à septembre inclus, et = S_Breaker_hiver si le jour courant appartient à une période allant d'octobre à mars inclus.

S_Limitation est le premier seuil prédéterminé et S_Breaker est le deuxième seuil prédéterminé.

On voit que, pour chaque période, les seuils prédéterminés sont définis ici au prorata de la durée de ladite période rapportée au seuil de référence quotidien correspondant (30kWh, 62kWh, 45kWh, 80kWh). Chaque jour courant, les seuils dépendent donc uniquement de la durée de la période concernée, et par ailleurs, les seuils dépendent de la période de l'année à laquelle appartient le jour courant (de la saison : été ou hiver).

Le microcontrôleur 11 vérifie alors si le temps présent correspond à la fin de la période courante : étape E4.

Si c'est le cas, le microcontrôleur 11 vérifie si la période courante est la dernière du jour courant, c'est-à-dire si :

Période = N (étape E5).

Si c'est le cas, le procédé repasse à l'étape E1. Sinon, le procédé passe à l'étape E2.

A l'étape E4, si le temps présent ne correspond pas à la fin de la période courante, le microcontrôleur 11 compare la consommation cumulée de l'installation 3 sur la période courante avec le premier seuil prédéterminé (S_Limitation) et avec le deuxième seuil prédéterminé (S_Breaker) : étape E6.

Si la consommation cumulée C est inférieure (ici strictement) au premier seuil prédéterminé (et donc au deuxième seuil prédéterminé), c'est-à-dire si :

C < S_Limitation et C < S_Breaker,
le microcontrôleur 11 ne réalise pas d'action particulière et le procédé repasse à l'étape E4.
Si la consommation cumulée est comprise entre le premier seuil prédéterminé (ici supérieure ou égale à celui-ci) et le deuxième seuil prédéterminé (ici inférieure strictement à celui-ci),
c'est-à-dire si :

S_Limitation ≤ C < S_Breaker,
le microcontrôleur 11 limite le courant fourni à l'installation 3. Pour cela, le microcontrôleur 11 active le limiteur de courant 20 en fermant le relais 21 puis, ensuite, en ouvrant l'interrupteur 10 de l'organe de coupure 9 : étape E7.

Le microcontrôleur 11 attend alors la fin de la période courante (étape E8), puis le procédé passe à l'étape E5.

A l'étape E6, si la consommation cumulée est supérieure (ici supérieure ou égale) au deuxième seuil prédéterminée,

c'est-à-dire si :
S_Breaker ≤ C,
le microcontrôleur 11 coupe le courant fourni à l'installation 3 en ouvrant le relais 21 et l'interrupteur 10 de l'organe de coupure 9 : étape E9.

Le microcontrôleur 11 attend alors la fin de la période courante (étape E8), puis le procédé passe à l'étape E5.

Dans le mode de réalisation qui vient d'être présenté, la vérification des conditions prédéterminées, permettant de décider de limiter ou de couper le courant au cours de la période courante, comprend donc l'étape de comparer la consommation cumulée de l'installation sur la période courante avec des seuils prédéterminés.

Dans un deuxième mode de réalisation, le microcontrôleur 11 ne tient pas compte des seuils de consommation. Le microcontrôleur 11 vérifie simplement, pour chaque période courante du jour courant, dans une table prédéfinie et préprogrammée dans l'une des mémoires 12, si, pendant ladite période courante, il est prévu : de limiter le courant fourni à l'installation ; de couper le courant ; de ne pas agir du tout sur le courant.

Ainsi, chaque jour courant, pour chaque période courante, le microcontrôleur 11 vérifie une première condition prédéterminée associée à ladite période courante. Si la première condition prédéterminée est vérifiée, le microcontrôleur 11 active le limiteur de courant pour limiter le courant fourni à l'installation 3 jusqu'à la fin de ladite période courante.

La vérification de la première condition prédéterminée consiste à vérifier, dans la table prédéfinie, que ladite période courante est associée à une première information selon laquelle le courant fourni à l'installation doit être limité pendant toute ladite période courante.

De même, le microcontrôleur 11 vérifie une deuxième condition prédéterminée associée à ladite période courante. Si la deuxième condition prédéterminée est vérifiée, le microcontrôleur 11 pilote l'organe de coupure 9 de manière à couper le courant fourni à l'installation 3 jusqu'à la fin de ladite période courante.

La vérification de la deuxième condition prédéterminée consiste à vérifier, dans la table prédéfinie, que ladite période courante est associée à une deuxième information selon laquelle le courant fourni à l'installation 3 doit être coupé pendant toute ladite période courante.

En revenant à la figure 2, la mise en œuvre de ce mode de réalisation consiste, à l'étape E6, à vérifier dans la table prédéfinie si une action est associée à la période courante. Les actions, correspondant à ce mode de réalisation, sont indiquées en gras sur la figure 2.

Si aucune action n'est prévue, le procédé repasse à l'étape E4.

Si l'action de limiter le courant est prévue, le procédé passe à l'étape E7.

Si l'action de couper le courant est prévue, le procédé passe à l'étape E9.

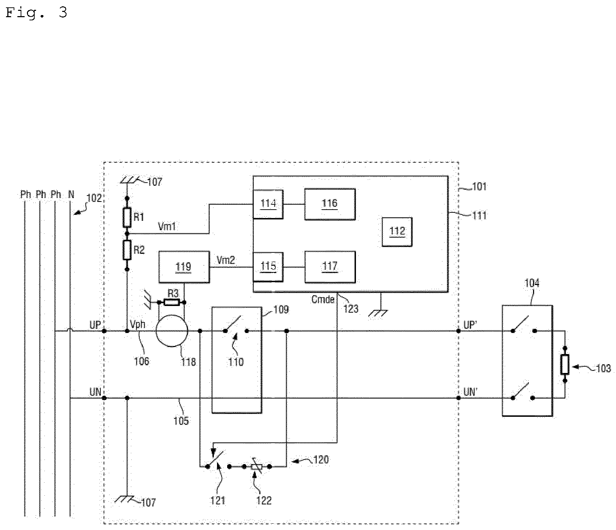

En référence à la figure 3, l'invention peut bien sûr être mise en œuvre avec un compteur électrique 101 qui n'est pas un compteur monophasé, mais triphasé.

Le réseau de distribution 102 comporte donc trois phases Ph et un neutre N.

Le circuit du compteur 101 est représenté pour une phase seulement sur la figure 3, mais le schéma est le même pour les 3 phases.

Un disjoncteur 104 est positionné à la frontière entre le réseau de distribution 102 et l'installation 103.

Pour chaque phase Ph du réseau 102, le compteur 101 comprend une borne d'entrée UP reliée à ladite phase Ph du réseau 102. Le compteur 101 comprend aussi une borne d'entrée UN reliée au neutre N. Le compteur 101 comprend de plus trois bornes de sortie UP' et une borne de sortie UN' reliées au disjoncteur 104, qui est lui-même relié à l'installation 103.

Le compteur 101 comporte un conducteur de neutre 105 relié à la borne d'entrée UN. Le conducteur de neutre 105 est relié à une masse électrique 107 du compteur 101.

Le compteur 101 comporte trois conducteurs de phase 106, chaque conducteur de phase 106 étant relié à une borne d'entrée UP distincte.

Le compteur 101 comprend de plus un organe de coupure 109 qui comprend trois interrupteurs 110, c'est-à-dire un interrupteur 110 monté sur chaque conducteur de phase 106.

La partie métrologie comprend un microcontrôleur de métrologie 111 qui intègre une ou des mémoires 112, un premier CAN 114, un deuxième CAN 115, un module de mesure de tension 116 et un module de mesure de courant 117.

Pour chaque phase, la partie métrologie comprend aussi un capteur de tension agencé pour produire des mesures de tension pour évaluer une tension de phase Vph présente sur ladite phase Ph. Le capteur de tension comprend ici un pont diviseur de tension comprenant une première résistance de mesure R1 et une deuxième résistance de mesure R2. Le premier CAN 114 numérise la tension Vm1.

Le premier CAN 114 comprend donc trois entrées reliées chacune au pont diviseur de tension associé à l'une des phases Ph.

Le module de mesure de tension 116 produit, à partir des échantillons produits par le premier CAN 114, des mesures de tension (efficace) permettant d'évaluer les tensions de phase Vph.

Pour chaque phase Ph, la partie métrologie comprend aussi un capteur de courant agencé pour produire des mesures de courant représentatives d'un courant de phase Iph circulant sur le conducteur de phase 106. Le capteur de courant comprend un tore 118 monté sur le conducteur de phase 106 en amont de l'interrupteur 110 de l'organe de coupure 109. Une troisième résistance de mesure R3 est montée entre les bornes de sortie du tore 118.

La partie métrologie comprend aussi une chaîne de mesure de courant 119 présentant un gain connu. La chaîne de mesure de courant 119 est reliée à une borne de la troisième résistance de mesure R3, l'autre borne de la résistance de mesure R3 étant reliée à la masse 107.

Le deuxième CAN 115 numérise la tension Vm2.

Le deuxième CAN 115 comprend donc trois entrées reliées chacune à la chaîne de mesure de courant 117 associée à l'une des phases Ph.

Le module de mesure de courant 117 produit, à partir des échantillons produits par le deuxième CAN 115, des mesures de courant permettant d'évaluer les courants de phase Iph.

Le compteur 101 comporte de plus un limiteur de courant 120 agencé pour limiter sélectivement le courant fourni à l'installation 3 (comprenant les courants de phase).

Pour chaque phase Ph, le limiteur de courant 120 est similaire à celui décrit sur la figure 1, et comprend un relais d'activation 121 de la limitation de courant, et un composant résistif 122 relié en série avec le relais 121. Le relais 121 et le composant résistif 122 sont montés en parallèle de l'interrupteur 110 de l'organe de coupure 109 qui est monté sur ladite phase Ph.

Les composants du limiteur 120 (relais, composant résistif de type CTP), présentés pour le compteur monophasé, peuvent être utilisés pour le compteur triphasé.

Le microcontrôleur 111 comprend une sortie unique 123 reliée aux trois relais, par laquelle le microcontrôleur 111 transmet aux relais un même signal de commande Cmde pour les piloter.

La commande Cmde est donc unique pour les trois phases Ph de manière à ce qu'elle soit simultanée (les trois relais d'activations 121 sont soit ouverts tous les trois, soit fermés tous les trois).

Le procédé de surveillance (et notamment le mode de réalisation présenté en figure 2) est mis en œuvre de la même manière que dans le cas du compteur monophasé 1.

Pour limiter le courant, le microcontrôleur 111 ferme tout d'abord les trois relais 121 simultanément, puis ensuite ouvre les trois interrupteurs 110 de l'organe de coupure 109 simultanément.

Pour couper le courant, le microcontrôleur 111 ouvre les trois relais 121 simultanément, et ouvre les trois interrupteurs 110 de l'organe de coupure 109 simultanément.

On note que le service, c'est-à-dire la surveillance et la limitation de la consommation, doit en pratique être « autorisé » par l'opérateur (c'est-à-dire par le distributeur d'énergie ou par le gestionnaire du réseau), en particulier lorsque des équipements sensibles pour la santé de l'utilisateur sont présents chez celui-ci.

On note aussi que les valeurs des durées Hk des périodes Pk sont typiquement déduites du profil de consommation typique correspondant aux courbes de charge qui donnent des valeurs de consommation toutes les 10 minutes ou toutes les 1/2 heure typiquement.

Bien entendu, l'invention n'est pas limitée aux modes de réalisation décrits mais englobe toute variante entrant dans le champ de l'invention tel que défini par les revendications.

L'invention s'applique bien sûr à tout compteur multiphasé (pas uniquement triphasé).

Le limiteur de courant peut être différent de celui décrit ici. Il pourrait s'agir par exemple, pour chaque conducteur de phase, d'un composant unique intégrant un interrupteur (ou relais) et un composant résistif, et monté directement sur le conducteur de phase.

On a indiqué que le procédé de surveillance est mis en œuvre dans le microcontrôleur de la partie métrologie.

Le procédé de surveillance pourrait aussi être mis en œuvre dans le microcontrôleur de la partie applicative.

Plus généralement, le procédé de surveillance peut être mis en œuvre dans une unité de traitement quelconque qui comprend au moins un composant de traitement et au moins une mémoire reliée ou intégrée dans l'un des composants de traitement. Le composant de traitement est par exemple un processeur « généraliste », un processeur spécialisé dans le traitement du signal (ou DSP, pour *Digital Signal Processor*), un microcontrôleur (comme c'est le cas ici), ou bien un circuit logique programmable tel qu'un FPGA (pour *Field Programmable Gate Arrays*) ou un ASIC (pour *Application Specific Integrated Circuit*).

Le procédé de surveillance, c'est-à-dire la surveillance de la consommation et le pilotage du limiteur de courant et de l'organe de coupure, n'est pas nécessairement mis en œuvre entièrement dans le compteur. Le procédé de surveillance pourrait être mis en œuvre au moins partiellement à l'extérieur du compteur.

Par exemple, l'opérateur (c'est-à-dire le distributeur d'énergie ou le gestionnaire du réseau) peut gérer à distance la commande Cmde du ou des relais du limiteur et celle du ou des interrupteurs de l'organe de coupure selon des périodes horaires quotidiennes préréglées pour chaque utilisateur final. Ainsi, dans certaines plages horaires de la journée, l'opérateur peut mettre en service chez l'utilisateur le limiteur de courant ou une coupure de courant pendant une durée prédéfinie. L'opérateur transmet alors les commandes au compteur via des moyens de communication quelconques (par exemple cellulaires, par courants porteurs en ligne, etc.), et pilote à distance le limiteur et l'organe de coupure (via le microcontrôleur 11 éventuellement).

L'opérateur pourrait aussi acquérir les mesures de consommation produites par le compteur (qui les transmet via les moyens de communication qui viennent d'être évoqués), puis vérifier, période par période, les conditions prédéterminées. L'opérateur transmet alors les commandes au compteur.

## Revendications

1. Procédé de surveillance, utilisant un compteur électrique (1 ; 101) agencé pour mesurer une consommation électrique d'une installation (3 ; 103) et comprenant un limiteur de courant (20 ; 120) agencé pour limiter sélectivement un courant fourni à l'installation, le procédé de surveillance comprenant les étapes, répétées chaque jour courant, pour chaque période courante d'un ensemble prédéterminé d'au moins une période successive définie dans le jour courant, de :

   - vérifier une première condition prédéterminée associée à ladite période courante ;
   - si la première condition prédéterminée est vérifiée, activer le limiteur de courant (20 ; 120) pour limiter le courant fourni à l'installation (3 ; 103) jusqu'à la fin de ladite période courante, le compteur électrique (1 ; 101) comprenant de plus un organe de coupure (9 ; 109) agencé pour couper sélectivement le courant fourni à l'installation, le procédé de surveillance comprenant en outre les étapes, pour chaque période courante, de :
   - vérifier une deuxième condition prédéterminée associée à ladite période courante ;
   - si la deuxième condition prédéterminée est vérifiée, piloter l'organe de coupure (9 ; 109) de manière à couper le courant fourni à l'installation jusqu'à la fin de ladite période courante.

2. Procédé de surveillance selon la revendication 1, dans lequel la première condition prédéterminée est qu'une consommation électrique cumulée de l'installation (3 ; 103) sur ladite période courante est supérieure à un premier seuil prédéterminé.

3. Procédé de surveillance selon la revendication 2, dans lequel la deuxième condition prédéterminée est qu'une consommation électrique cumulée de l'installation (3 ; 103) sur ladite période courante est supérieure à un deuxième seuil prédéterminé lui-même supérieur au premier seuil prédéterminé.

4. Procédé de surveillance selon l'une des revendications 2 ou 3, dans lequel le premier seuil prédéterminé et/ou le deuxième seuil prédéterminé dépendent de ladite période courante et/ou dudit jour courant et/ou d'une période de l'année à laquelle appartient ledit jour courant.

5. Procédé de surveillance selon la revendication 1, dans lequel la vérification de la première condition prédéterminée consiste à vérifier, dans une table prédéfinie, que ladite période courante est associée à une première information selon laquelle le courant fourni à l'installation (3 ; 103) doit être limité pendant toute ladite période courante.

6. Procédé de surveillance selon la revendication 5, dans lequel la vérification de la deuxième condition prédéterminée consiste à vérifier, dans la table prédéfinie, que ladite période courante est associée à une deuxième information selon laquelle le courant fourni à l'installation doit être coupé pendant toute ladite période courante.

7. Procédé de surveillance selon l'une des revendications précédentes, le compteur comprenant de plus un organe de coupure (9 ; 109) agencé pour couper sélectivement le courant fourni à l'installation, l'organe de coupure comprenant un interrupteur (10 ; 110) pour chaque phase d'un réseau de distribution auquel est reliée l'installation, le limiteur de courant (20 ; 120) comprenant, pour chaque interrupteur de l'organe de coupure, un relais (21 ; 121) et un composant résistif (22 ; 122) montés en parallèle de l'interrupteur, l'activation du limiteur de courant pour limiter le courant fourni à l'installation comprenant les étapes de fermer le ou les relais simultanément puis, ensuite, d'ouvrir le ou les interrupteurs simultanément.

8. Compteur électrique (1 ; 101) agencé pour mesurer une consommation électrique d'une installation (3 ; 103), le compteur électrique comprenant un limiteur de courant (20 ; 120) agencé pour limiter sélectivement un courant fourni à l'installation et un organe de coupure (9,109) agencé pour couper sélectivement le courant fourni à l'installation, le compteur électrique comprenant en outre une unité de traitement (11 ; 111) agencée pour mettre en œuvre le procédé de surveillance selon l'une des revendications précédentes.

9. Compteur électrique selon la revendication 8, l'organe de coupure comprenant un interrupteur (10 ; 110) pour chaque phase d'un réseau de distribution auquel est reliée l'installation, le limiteur de courant (20 ; 120) comprenant, pour chaque interrupteur de l'organe de coupure, un relais (21 ; 121) et un composant résistif (22 ; 122) montés en parallèle de l'interrupteur, l'unité de traitement étant agencée, pour activer le limiteur de courant, pour fermer le ou les relais simultanément puis, ensuite, pour ouvrir le ou les interrupteurs simultanément.

10. Programme d'ordinateur comprenant des instructions qui conduisent l'unité de traitement (11 ; 111) du compteur électrique (1 ; 101) selon l'une des revendications 8 à 9 à exécuter les étapes du procédé de surveillance selon l'une des revendications 1 à 7.

11. Support d'enregistrement lisible par ordinateur, sur lequel est enregistré le programme d'ordinateur selon la revendication 10.

**Patentansprüche**

1. Überwachungsverfahren, das einen Stromzähler (1; 101) zur Messung eines Stromverbrauchs einer Anlage (3; 103) verwendet und einen Strombegrenzer (20; 120) zum selektiven Begrenzen eines an die Anlage bereitgestellten Stroms umfasst, wobei das Überwachungsverfahren die folgenden Schritte umfasst, die sich an jedem laufenden Tag während jedes laufenden Zeitraums aus einer vorbestimmten Gesamtheit bestehend aus besagtem Zeitraum und aus zumindest einem an dem laufenden Tag definierten Folgezeitraum wiederholen, nämlich dass:

   - eine erste, dem laufenden Zeitraum zugeordnete vorbestimmte Bedingung überprüft wird;
   - nach erfolgter Überprüfung der ersten vorbestimmten Bedingung der Strombegrenzer (20; 120) aktiviert wird, um den an die Anlage (3; 103) bereitgestellten Strom bis zum Ende des laufenden Zeitraums zu begrenzen,

   wobei der Stromzähler (1; 101) außerdem ein Abschaltorgan (9; 109) zum selektiven Abschalten des an die Anlage bereitgestellten Stroms umfasst, wobei das Überwachungsverfahren ferner die Schritte umfasst, dass für jeden laufenden Zeitraum:

   - eine zweite, dem laufenden Zeitraum zugeordnete vorbestimmte Bedingung überprüft wird;
   - nach erfolgter Überprüfung der zweiten vorbestimmten Bedingung das Abschaltorgan (9; 109) derart angesteuert wird, dass der an die Anlage bereitgestellten Strom abgeschaltet wird und bis zum Ende des laufenden Zeitraums abgeschaltet bleibt.

2. Überwachungsverfahren nach Anspruch 1, wobei die erste vorbestimmte Bedingung darin besteht, dass ein über den laufenden Zeitraum hinweg kumulierter Stromverbrauch der Anlage (3; 103) über einem ersten vorbestimmten Schwellenwert liegt.

3. Überwachungsverfahren nach Anspruch 2, wobei die zweite vorbestimmte Bedingung darin besteht, dass ein über den laufenden Zeitraum hinweg kumulierter Stromverbrauch der Anlage (3; 103) über einem zweiten vorbestimmten Schwellenwert liegt, welcher seinerseits größer ist als der erste Schwellenwert.

4. Überwachungsverfahren nach einem der Ansprüche 2 oder 3, wobei der erste vorbestimmte Schwellenwert und/oder der zweite vorbestimmte Schwellenwert von dem laufenden Zeitraum und/oder von dem laufenden Tag und/oder von einem Jahreszeitraum, zu welchem der laufende Tag gehört, abhängig ist.

5. Überwachungsverfahren nach Anspruch 1, wobei die Überprüfung der ersten vorbestimmten Bedingung darin besteht, dass anhand einer vorgegebenen Tabelle überprüft wird, ob der laufende Zeitraum einer ersten Information zugeordnet ist, gemäß welcher der an die Anlage (3; 103) bereitgestellte Strom während des gesamten laufenden Zeitraums zu begrenzen ist.

6. Überwachungsverfahren nach Anspruch 5, wobei die Überprüfung der zweiten vorbestimmten Bedingung darin besteht, dass anhand der vorgegebenen Tabelle überprüft wird, ob der laufende Zeitraum einer zweiten Information zugeordnet ist, gemäß welcher der an die Anlage bereitgestellte Strom abzuschalten ist und während des gesamten laufenden Zeitraums abgeschaltet bleibt.

7. Überwachungsverfahren nach einem der vorhergehenden Ansprüche, wobei der Zähler außerdem ein Abschaltorgan (9; 109) zum selektiven Abschalten des an die Anlage bereitgestellten Stroms umfasst, wobei das Abschaltorgan einen Schalter (10; 110) für jede Phase eines Verteilungsnetzes, mit dem die Anlage verbunden ist, umfasst, wobei der Strombegrenzer (20; 120) für jeden Schalter des Abschaltorgans ein Relais (21; 121) und eine Widerstandskomponente (22; 122) umfasst, die parallel zu dem Schalter geschaltet sind, wobei die Aktivierung des Strombegrenzers zur Begrenzung des an die Anlage bereitgestellten Stroms die Schritte umfasst, dass das oder die Relais gleichzeitig geschlossen und anschließend der oder die Schalter gleichzeitig geöffnet werden.

8. Stromzähler (1; 101) zur Messung eines Stromverbrauchs einer Anlage (3; 103), wobei der Stromzähler einen Strombegrenzer (20; 120) zum selektiven Begrenzen eines an die Anlage bereitgestellten Stroms und ein Abschaltorgan (9; 109) zum selektiven Abschalten des an die Anlage bereitgestellten Stroms umfasst, wobei der Stromzähler ferner eine Verarbeitungseinheit (11; 111) zur Durchführung des Überwachungsverfahrens nach einem der vorhergehenden Ansprüche umfasst.

9. Stromzähler nach Anspruch 8, wobei das Abschaltorgan einen Schalter (10; 110) für jede Phase eines Verteilungsnetzes, mit dem die Anlage verbunden ist, umfasst, wobei der Strombegrenzer (20; 120) für jeden Schalter des Abschaltorgans ein Relais (21; 121) und eine Widerstandskomponente (22; 122) umfasst, die parallel zu dem Schalter geschaltet sind, wobei die Verarbeitungseinheit dafür ausgelegt ist, den Strombegrenzer zu aktivieren, das oder die Relais gleichzeitig zu schließen und anschließend den oder die Schalter gleichzeitig zu öffnen.

10. Computerprogramm, das Befehle umfasst, welche die Verarbeitungseinheit (11; 111) des Stromzählers (1; 101) nach einem der Ansprüche 8 bis 9 dazu veranlassen, die Schritte des Überwachungsverfahrens nach einem der Ansprüche 1 bis 7 auszuführen.

11. Computerlesbares Speichermedium, auf welchem das Computerprogramm nach Anspruch 10 abgespeichert ist.

**Claims**

1. Monitoring method, using an electricity meter (1; 101) arranged to measure an electricity consumption of an installation (3; 103) and comprising a current limiter (20; 120) arranged to selectively limit a current supplied to the installation, the monitoring method comprising the steps, repeated each current day, for each current period of a predetermined set of at least one successive period defined in the current day, of:

    - verifying a first predetermined condition associated with said current period;
    - if the first predetermined condition is verified, activating the current limiter (20; 120) to limit the current supplied to the installation (3; 103) until the end of said current period,
    the electricity meter (1; 101) in addition comprising a cutoff member (9; 109) arranged to selectively cut off the current supplied to the installation, the monitoring method further comprising the steps, for each current period, of:
    - verifying a second predetermined condition associated with said current period;
    - if the second predetermined condition is verified, operating the cutoff member (9; 109) so as to cut off the current supplied to the installation until the end of said current period.

2. Monitoring method according to claim 1, wherein the first predetermined condition is that a cumulated electricity consumption of the installation (3; 103) over said current period is greater than a first predetermined threshold.

3. Monitoring method according to claim 2, wherein the second predetermined condition is that a cumulated electricity consumption of the installation (3; 103) over said current period is greater than a second predetermined threshold, itself greater than the first predetermined threshold.

4. Monitoring method according to one of claims 2 or 3, wherein the first predetermined threshold and/or the second predetermined threshold depend on said current period and/or on said current day and/or on a period of the year to which said current day belongs.

5. Monitoring method according to claim 1, wherein the verification of the first predetermined condition consists of verifying, in a predefined table, that said current period is associated with a first piece of information, according to which the current supplied to the installation (3; 103) must be limited for the whole of said current period.

6. Monitoring method according to claim 5, wherein the verification of the second predetermined condition consists of verifying, in the predefined table, that said current period is associated with a second piece of information, according to which the current supplied to the installation must be cut off for the whole of said current period.

7. Monitoring method according to one of the preceding claims, the meter in addition comprising a cutoff member (9; 109) arranged to selectively cut off the current supplied to the installation, the cutoff member comprising a switch (10;= 110) for each phase of a distribution network to which the installation is connected, the current limiter (20; 120) comprising, for each switch of the cutoff member, a relay (21; 121) and a resistive component (22; 122) mounted in parallel of the switch, the activation of the current limiter to limit the current supplied to the installation comprising the steps of closing the relay(s) simultaneously then of opening the switch(es) simultaneously.

8. Electricity meter (1; 101) arranged to measure an electricity consumption of an installation (3; 103), the electricity meter comprising a current limiter (20; 120) arranged to selectively limit a current supplied to the installation and a cutoff member (9, 109) arranged to selectively cut off the current supplied to the installation, the electricity meter further comprising a processing unit (11; 111) arranged to implement the monitoring method according to one of the preceding claims.

9. Electricity meter according to claim 8, the cutoff member comprising a switch (10; 110) for each phase of a distribution network to which the installation is connected, the current limiter (20; 120) comprising, for each switch of the cutoff member, a relay (21; 121) and a resistive component (22; 122) mounted in parallel of the switch, the processing unit being arranged, to activate the current limiter, to close the relay(s) simultaneously, then to open the switch(es) simultaneously.

10. Computer program comprising instructions which lead the processing unit (11; 111) of the electricity meter (1; 101) according to one of claims 8 to 9, to execute the steps of the monitoring method according to one of claims 1 to 7.

11. Recording medium which can be read by a computer, on which the computer program is recorded according to claim 10.

Fig. 1

Fig. 2

Début — E0

Période = 0 — E1

OUI

Période = N ?    NON    E5

Fermeture Breaker(s) et ouverture Relais
Période = Période + 1 — E2

E3

S_Limitation_été = 30kWh*Hk/24
S_Limitaion_hiver = 62kWh*Hk/24
S_Limitation = S_Limitation_eté si période avril à septembre inclus et =
S_Limitation_hiver si période octobre à mars inclus
S_Breaker_été = 45kWh*Hk/24
S_Breaker_hiver = 80kWh*Hk/24
S_Breaker = S_Breaker_été si période avril à septembre inclus et = S_Breaker_hiver si
période octobre à mars inclus
C = 0 (consommation cumulée sur la période)

OUI    Fin de la Période k ?    E4

NON    E6

< S_Limitation et
< S_Breaker

Variante : Action
Ne rien faire

C ?

Action ?

≥ S_Breaker

≥ S_Limitation et
< S_Breaker

Variante : Action
Ouvrir le(s)
Breaker(s)

Variante : Action
Limiter le courant

Fermeture Relais puis
Ouverture Breaker(s) — E7

Ouverture Relais puis
Ouverture Breaker(s) — E9

Attente fin de la Période k — E8

Fig. 3

**EP 4 350 925 B1**

**Documents brevets cités dans la description**

- WO 2014147959 A